# EUROPEAN PATENT APPLICATION

(11) **EP 4 726 781 A1**
(43) Date of publication of application: **15.04.2026**
(21) Application number: 24819038.1
(22) Date of filing: 18.04.2024
(51) Int. Cl.: H01L 29/16, H01L 21/338, H01L 29/778, H01L 29/812, H01P 5/02

(54) **INTEGRATED CIRCUIT AND METHOD FOR MANUFACTURING SAME**

(30) Priority: 09.06.2023 JP 2023095712
(71) Applicant: Tohoku University, Sendai-shi, Miyagi 980-8577 (JP); National Institute of Information and Communications Technology, Koganei-shi, Tokyo 184-8795 (JP); Shin-Etsu Chemical Co., Ltd., Chiyoda-ku Tokyo 100-0005 (JP)
(72) Inventor: FUKIDOME, Hirokazu, Sendai-shi, Miyagi 980-8577 (JP); SUEMITSU, Tetsuya, Sendai-shi, Miyagi 980-8577 (JP); WATANABE, Issei, Koganei-shi, Tokyo 184-8795 (JP); KAWAHARA, Minoru, Tokyo 100-0005 (JP); AKIYAMA, Shoji, Annaka-shi, Gunma 379-0195 (JP); TOBISAKA, Yuji, Annaka-shi, Gunma 379-0195 (JP); KAWAI, Makoto, Annaka-shi, Gunma 379-0195 (JP)
(74) Representative: Vossius & Partner Patentanwälte Rechtsanwälte mbB
(86) International application number: PCT/JP2024/015407
(87) International publication number: WO 2024/252800

(57) **Abstract**

An integrated circuit suitable for use in signal frequency bands of 1 THz or higher is provided.

The integrated circuit comprises: a substrate at least whose uppermost plane is a single crystal of silicon carbide with a vertical plane intersecting the uppermost plane and extending downwardly therefrom, and a lower plane substantially parallel to the uppermost plane and intersecting the vertical plane; and a single-crystal graphene layer provided in contact with the uppermost plane of the substrate. In the integrated circuit, a short-gate-length transistor and an antenna element are integrally formed. The short-gate-length transistor comprises: a gate electrode at the edge where the graphene layer intersects the vertical plane; an insulating film formed to cover at least the vertical plane and edges of the graphene layer; a two-dimensional semiconductor layer formed to cover the uppermost plane, the vertical plane, and the lower plane, the two-dimensional semiconductor layer being also formed to cover the graphene layer and/or insulating film at a portion where the graphene layer and/or insulating film exist; a source electrode provided at a portion where the uppermost plane is covered by the two-dimensional semiconductor layer; and a drain electrode provided at a portion where the lower plane is covered by the two-dimensional semiconductor layer. The antenna element is formed by patterning the graphene layer.

## Description

### TECHNICAL FIELD

The present invention relates to an integrated circuit with graphene formed on a silicon carbide substrate used as wiring or electrodes, and a method for manufacturing the same.

### BACKGROUND ART

In order to realize next-generation mobile communication systems (so-called 6G and Beyond 5G), high-performance antennas suitable for transmitting and receiving at high frequencies, such as 100 GHz and above, are required. As a candidate for such an antenna, an antenna using graphene as the antenna element has been proposed, which has superior properties (high electrical conductivity, high carrier mobility, and high thermal conductivity) compared to copper, ITO (Indium Tin Oxide), and other materials conventionally used as conductors in antenna elements (see, for example, Patent Document 1).

In the microwave band antenna described in Patent Document 1, a graphene film formed by the CVD method on a copper foil is transferred to a substrate, an Au film is provided on the transferred graphene film as appropriate, and the antenna element is formed by patterning with photolithography, etching, UV-ozone treatment, etc. In this way, an antenna element of the desired shape can be fabricated on the substrate.

### PRIOR ART DOCUMENTS

### PATENT DOCUMENTS

Patent Document 1: JP2019-75626A

### SUMMARY OF THE INVENTION

### PROBLEMS TO BE SOLVED BY THE INVENTION

The antenna used in a mobile communication system, by the way, is used together with an amplifier that amplifies the signal transmitted or received by the antenna element. In the signal frequency band from several 10 GHz to above 100 GHz, the transmission distance between the amplifier and the antenna element should be extremely short (e.g., less than 100 µm). In addition, looking ahead to the next generation of mobile communication systems operating beyond the 1 THz frequency band, active devices suitable for use in signal frequency bands exceeding 1 THz are required that differ from gallium nitride (GaN) active devices. Furthermore, when transitioning from signal frequency bands of several 10G to 100GHz or higher to bands exceeding 1 THz or higher, devices capable of covering both bands are required (for example, by combining several types of active devices).

The present invention has been conceived in light of the above, and the object of the present invention is to provide an integrated circuit suitable for use in a signal frequency band of 1 THz or higher and a method for manufacturing the same.

### MEANS FOR SOLVING THE PROBLEMS

An integrated circuit according to an embodiment of the present invention comprises: a substrate at least whose uppermost plane is a single crystal of silicon carbide (SiC) with a vertical plane intersecting the uppermost plane and extending downwardly therefrom and a lower plane substantially parallel to the uppermost plane and intersecting the vertical plane; and a single-crystal graphene layer provided in contact with the uppermost plane of the substrate, wherein a short-gate-length transistor and an antenna element are integrally formed. The short-gate-length transistor comprises: a gate electrode at the edge where the graphene layer intersects the vertical plane; an insulating film formed to cover at least the vertical plane and edges of the graphene layer; a two-dimensional semiconductor layer formed to cover the uppermost plane, the vertical plane, and the lower plane, the two-dimensional semiconductor layer being also formed to cover the graphene layer and/or insulating film at a portion where the graphene layer and/or insulating film exist; a source electrode provided at a portion where the uppermost plane is covered by the two-dimensional semiconductor layer; and a drain electrode provided at a portion where the lower plane is covered by the two-dimensional semiconductor layer. The antenna element is formed by patterning the graphene layer.

In the present invention, in the graphene layer, the portion constituting the gate electrode in the short gate length transistor and the portion constituting the antenna element may be formed as a continuous graphene film.

In the present invention, the integrated circuit may be further provided with a gallium nitride layer in the area on the substrate where the short-gate-length transistor and antenna element are not provided, and active elements may be formed in the gallium nitride layer.

Another example of an integrated circuit according to an embodiment of the present invention comprises: a substrate at least whose uppermost plane is a single crystal of silicon carbide with a vertical plane intersecting the uppermost plane and extending downwardly therefrom and a lower plane substantially parallel to the uppermost plane and intersecting the vertical plane; a single-crystal graphene layer provided in contact with the uppermost plane of the substrate; and a gallium nitride layer on the substrate, wherein an active element portion formed on the gallium nitride layer and a short-gate-length transistor using the graphene layer as a gate are integrally formed. In the integrated circuit, the short-gate-length transistor comprises: a gate electrode at the edge where the graphene layer intersects the vertical plane; an insulating film formed to cover at least the vertical plane and edges of the graphene layer; a two-dimensional semiconductor layer formed to cover the uppermost plane, the vertical plane, and the lower plane, the two-dimensional semiconductor layer being also formed to cover the graphene layer and/or insulating film at a portion where the graphene layer and/or insulating film exist; a source electrode provided at a portion where the uppermost plane is covered by the two-dimensional semiconductor layer; and a drain electrode provided at a portion where the lower plane is covered by the two-dimensional semiconductor layer.

In the present invention, the short-gate-length transistor may further include a shielding layer of a conductor on the graphene layer constituting the gate, and an insulating layer may be provided on both the front and back sides of the shielding layer. Furthermore, at least the edge portion of the graphene layer may be a monatomic layer of graphene.

In the present invention, the substrate may include an inclined plane that is non-parallel to the uppermost plane, positioned distant from the edge where the uppermost plane and the vertical plane intersect. The graphene layer may be formed extending from the uppermost plane across the inclined plane. Furthermore, the graphene layer on the inclined plane may be multilayer graphene.

In the present invention, the substrate may be a hybrid substrate with a single crystal layer of silicon carbide fabricated on an insulator base substrate.

In the configuration of the present invention with a gallium nitride layer, the gallium nitride layer may be provided to cover a portion of the graphene layer. In this case, the gallium nitride layer may be a layer epitaxially grown on the graphene layer as a buffer layer. The active element formed in the gallium nitride layer may include an amplifier using a HEMT (High Electron Mobility Transistor).

The method for manufacturing an integrated circuit according to an embodiment of the present invention is a method for manufacturing an integrated circuit in which a short-gate-length transistor and an antenna element are integrally formed. The method for manufacturing comprises: a step of preparing a substrate at least whose uppermost plane is a single crystal of silicon carbide; a step of forming a graphene layer on the uppermost plane of the substrate; in the area of the first region of the substrate where the short-gate-length transistor is formed: a step of forming, by microfabrication, on the substrate, a vertical plane intersecting the uppermost plane and extending downward therefrom, and a lower plane substantially parallel to the uppermost plane and intersecting the vertical plane, while leaving a portion of the graphene layer intact, by removing the graphene layer and the upper portion of the substrate from other portion; a step of depositing an insulating film to cover at least the vertical plane and edges of the graphene layer; a step of depositing two-dimensional semiconductor layer to cover the uppermost plane, the vertical plane, and the lower plane, and to also cover the graphene layer and/or insulating film at a portion where the graphene layer and/or insulating film exist; a step of forming an electrode overlaid on a portion where the graphene layer is covered by the two-dimensional semiconductor layer, and forming an electrode overlaid on a portion where the lower plane is covered by the two-dimensional semiconductor layer; and a step of forming an antenna element by patterning the graphene layer, in the second region, where the antenna element is formed, of the substrate.

The present invention may further comprise: a step of epitaxially growing a gallium nitride layer with the graphene layer as a buffer layer; a step of removing the gallium nitride layer to expose the graphene layer in the first region and the second region; and a step of forming an active element portion including an amplifier on the remaining gallium nitride layer.

Alternatively, the present invention may further comprise the steps of: a step of epitaxially growing a gallium nitride layer in the area where the graphene layer has been removed; a step of forming an active element portion including an amplifier in the gallium nitride layer. In this case, the first region and the second region may be provided in the region where the graphene layer remains.

Another example of the method for manufacturing an integrated circuit according to an embodiment of the present invention comprises: a step of preparing a substrate at least whose uppermost plane is a single crystal of silicon carbide; a step of forming a graphene layer on the uppermost plane of the substrate; a step of epitaxially growing a gallium nitride layer using the graphene layer as a buffer layer; a step of exposing the graphene layer by removing the area of the short-gate-length transistor in which the active element portion is not provided; a step of forming, by microfabrication, on the substrate, a vertical plane intersecting the uppermost plane and extending downward therefrom, and a lower plane substantially parallel to the uppermost plane and intersecting the vertical plane, while leaving a portion of the graphene layer intact, by removing the graphene layer and the upper portion of the substrate from other portion; a step of depositing an insulating film to cover at least the vertical plane and edges of the graphene layer; a step of depositing a two-dimensional semiconductor layer to cover the uppermost plane, the vertical plane, and the lower plane, and to also cover the graphene layer and/or insulating film at a portion where the graphene layer and/or insulating film exist; a step of forming an electrode overlaid on a portion where the graphene layer is covered by the two-dimensional semiconductor layer, and forming an electrode overlaid on a portion where the lower plane is covered by the two-dimensional semiconductor layer; and a step of forming an active element portion including an amplifier on the remaining gallium nitride layer.

Yet another example of the method for manufacturing an integrated circuit according to an embodiment of the present invention comprises: a step of preparing a substrate at least whose uppermost plane is a single crystal of silicon carbide; a step of forming a graphene layer on the uppermost plane of the substrate; a step of removing a portion of the graphene layer; a step of epitaxially growing a gallium nitride layer in the area where the graphene layer has been removed; a step of forming an active element portion including an amplifier in the gallium nitride layer; in a region where the graphene layer remains: a step of forming, by microfabrication, on the substrate, a vertical plane intersecting the uppermost plane and extending downward therefrom, and a lower plane substantially parallel to the uppermost plane and intersecting the vertical plane, while leaving a portion of the graphene layer intact, by removing the graphene layer and the upper portion of the substrate from other portion; a step of depositing an insulating film to cover at least the vertical plane and edges of the graphene layer; a step of depositing a two-dimensional semiconductor layer to cover the uppermost plane, the vertical plane, and the lower plane, and to also cover the graphene layer and/or insulating film at a portion where the graphene layer and/or insulating film exist; and a step of forming an electrode overlaid on a portion where the graphene layer is covered by the two-dimensional semiconductor layer, and forming an electrode overlaid on a portion where the lower plane is covered by the two-dimensional semiconductor layer.

The method for manufacturing according to any of the above examples may include a step of providing a gallium nitride layer by bonding a gallium nitride device with an active element portion including an amplifier to the graphene layer on the substrate.

In the present invention, in the step of forming the antenna element, an electrode pad and a connection portion connecting the antenna element to the electrode pad may be formed together with the antenna element, and in the step of providing the gallium nitride layer, the gallium nitride device may be bonded to the graphene layer on the substrate so that an electrode on the gallium nitride device and the electrode pad are electrically connected.

In the present invention, in the step of forming the graphene layer, the graphene layer may be epitaxially grown by sublimating the silicon atoms in a single crystal of silicon carbide on the uppermost plane of the substrate.

In the present invention, the substrate may be a hybrid substrate with a single crystal layer of silicon carbide fabricated on an insulator base substrate.

### EFFECTS OF THE INVENTION

According to the integrated circuit and method for manufacturing the same of the present invention, an integrated circuit suitable for use in signal frequency bands of 1 THz or higher can be realized.

### BRIEF DESCRIPTION OF THE DRAWINGS

Fig. 1 is a schematic diagram showing the structure of integrated circuit 1.
Fig. 2 is a cross-sectional diagram showing the basic structure of the short-gate-length transistor formed in the first region R1.
Fig. 3 is a cross-sectional diagram showing the structure of a modified example of the short-gate-length transistor.
Fig. 4 is a schematic diagram showing the structure with a GaN layer formed in the third region R3.
Fig. 5 shows the first example of a procedure for fabricating the integrated circuit 1.
Fig. 6 shows a procedure for manufacturing the short-gate-length transistor.
Fig. 7 shows the second example of a procedure for fabricating the integrated circuit 1.

### EMBODIMENTS OF THE INVENTION

Hereinafter, embodiments of the present invention will be described. Common components in each drawing, including the drawings used to explain the background technology, are indicated by the same reference sign.

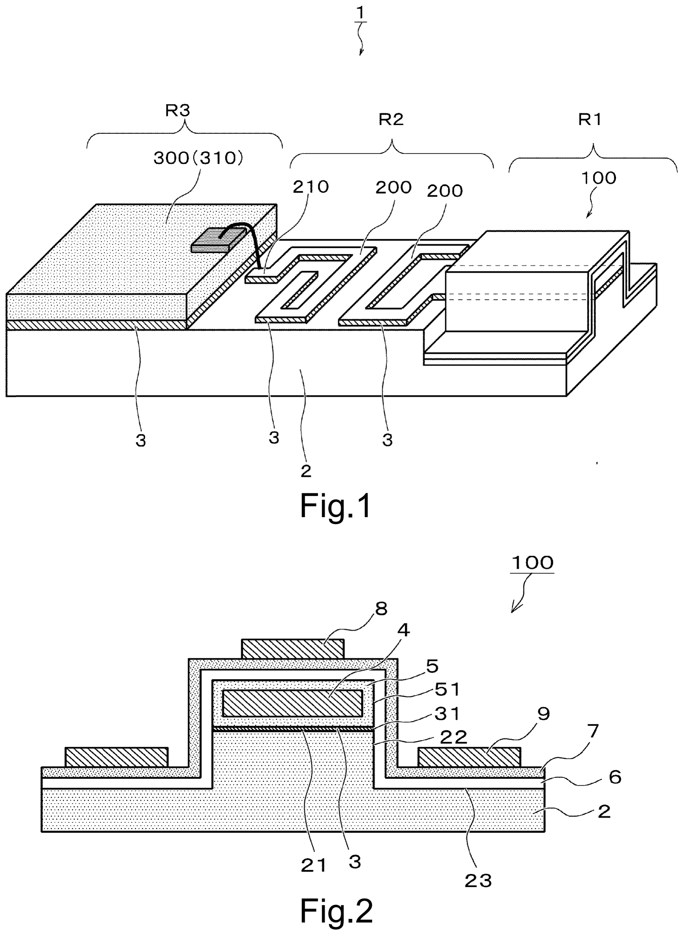

Fig. 1 is a schematic diagram of the structure of an integrated-circuit 1 according to the embodiment of the present invention. As shown in Fig. 1, the integrated circuit 1 is structured with a first region R1, a second region R2, and a third region R3 on a substrate 2. The first region R1 is the region where a short-gate-length transistor 100 is formed. The second region R2 is the region where an antenna element 200 is formed. The third region R3 is the region where a gallium nitride device 310 is formed. Thus, the integrated circuit 1 is composed of the short-gate-length transistor 100, the antenna element 200, and the GaN device 310, formed on a single substrate. The short-gate-length transistor 100, antenna element 200, and GaN device 310 on substrate 2 are interconnected as necessary to achieve the desired functionality.

At least the uppermost plane 21 of substrate 2 is made of single-crystal silicon carbide. The uppermost plane 21 is the uppermost flat surface in the substrate 2. The rest of the substrate 2, except the uppermost plane, may be an insulator different from silicon carbide. That is, the substrate 2 may be a single-crystal substrate of silicon carbide or a hybrid substrate with a single-crystal layer of silicon carbide fabricated on an insulator. The surface of the single-crystal layer of silicon carbide in the substrate 2 may be (0001) surface. The substrate 2 is the basis for epitaxial growth of graphene that forms the graphene layer 3. The graphene layer 3 is a thin film of graphene consisting of a single atomic layer or several atomic layers formed adjacent to the uppermost plane 21 of the substrate 2. The graphene forming the graphene layer 3 can be formed as a single-layer thin film on the (0001) plane of silicon carbide, which is suitable as the substrate 2.

Hereinafter, configuration examples and modification examples for the first region R1, second region R2, and third region R3 on the substrate 2 will be described respectively.

Fig. 2 is a cross-sectional diagram showing the basic structure of the short-gate-length transistor 100 formed in the first region R1. As shown in Fig. 2, the short-gate-length transistor 100 comprises the graphene layer 3, a shielding layer 4, an insulating layer 5, an insulating film 6, a two-dimensional semiconductor layer 7, an electrode 8, and an electrode 9 on the substrate 2. In the basic structure of the short-gate-length transistor 100, the substrate 2 has a vertical plane 22 and a lower plane 23, which are formed by digging down from the uppermost plane 21. The vertical plane 22 is a plane that intersects the uppermost plane 21 and extends downwardly from the uppermost plane 21. In the example in Fig. 2, the vertical plane 22 and the uppermost plane 21 are perpendicular to each other. The lower plane 23 is formed as a plane substantially parallel to the uppermost plane 21 and intersects the vertical plane 22. In the example of Fig. 2, the lower plane 23 is perpendicular to the vertical plane 22, and the uppermost plane 21 and the lower plane 23 are parallel The vertical plane 22 is formed as a plane intersecting both the uppermost plane 21 and the lower plane 23.

In the short-gate-length transistor 100 formed in the first region R1, the thickness of the graphene layer 3 is set to be several nm or less. The width of the graphene layer 3 from one end to the other (in the horizontal direction in Fig. 2) is preferably set to be about 100 nm to 1 µm. The graphene layer 3 is provided to cover the uppermost plane 21 up to the vicinity of the ridge where the uppermost plane 21 and the vertical plane 22 intersect on the substrate 2. The edge 31 of the graphene layer 3, which overlaps the vicinity of the ridge where the uppermost plane 21 intersects with the vertical plane 22, functions as the gate in the short-gate-length transistor 100. Furthermore, the portion of the graphene layer 3 other than the aforementioned edge 31 functions as wiring to the gate described later.

In the short-gate-length transistor 100 formed in the first region R1, the shielding layer 4 is a layer of a conductor such as metal provided on the graphene layer 3, shielding the space between the electrode 8 and the graphene layer 3. The shielding layer 4 is electrically connected to a predetermined ground potential (e.g., 0V). An insulating layer 5 is provided on at least both the front and back surfaces of the shielding layer 4 to prevent the shielding layer 4 from short-circuiting with the graphene layer 3 or the electrode 8. Aluminum (Al) or nickel (Ni) is preferred as the shielding layer 4. When Al is used as the shielding layer 4, the natural oxide film formed on the surface of Al can be used as the insulating layer 5 as it is, simplifying the manufacturing process. When using Ni as the shielding layer 4, it is necessary to form a separate insulating layer 5 to prevent short circuits with the graphene layer 3 or the electrode 8. When there is no need to shield the space between the electrode 8 and the graphene layer 3 (for example, when signal interference between the electrode 8 and the graphene layer 3 is not a problem), the shielding layer 4 and the insulating layer 5 may not be provided. The end plane 51 of the insulating layer 5 may be a plane that is roughly coincident with the vertical plane 22.

The insulating film 6 is a thin film of insulator that serves as the gate insulating film of the short-gate-length transistor 100. As insulating film 6, a high dielectric constant insulating film such as hafnium oxide, silicon carbide, zirconium oxide, erbium oxide, aluminum oxide, or a thin film of silicon carbide can be used. A thin film of silicon carbide is suitable for high-frequency applications such as those above 1 THz. In the example shown in Fig. 2, the insulating film 6 is formed to cover the top surface of the insulating layer 5, extending down through the end plane 51, edge 31, and vertical plane 22 to the lower plane 23. As long as the insulating film 6 covers at least the vertical plane 22, edge 31, and end face 51 of the substrate 2, it may not be necessary to be formed on other portions. For example, in a configuration with the insulating layer 5 and the shielding layer 4, there is no need to provide the insulating film 6 on the insulating layer 5. On the other hand, in the configuration without the insulating layer 5 and the shielding layer 4, the insulating film 6 must be provided between the graphene layer 3 and the electrode 8 as well to prevent a short circuit between the graphene layer 3 and the electrode 8. If the substrate 2 has sufficient insulating properties, it is not necessary to provide insulating film 6 on the lower plane 23.

The two-dimensional semiconductor layer 7 is a layer of semiconductors that serves as the carrier transport layer of the short-gate-length transistor 100. The two-dimensional semiconductor layer 7 is formed to cover the uppermost plane 21, the vertical plane 22, and the lower plane 23. For portions where there is the graphene layer 3, the shielding layer 4, the insulating layer 5, and/or the insulating film 6, the two-dimensional semiconductor layer 7 is formed overlaid to cover these as well. For the two-dimensional semiconductor layer 7, mono or multi-atomic layers of graphene, transition metal dichalcogenide (e.g., molybdenum disulfide (MoS₂), tungsten disulfide (WS₂), tungsten diselenide (WSe₂)), indium oxide (In₂O₃), boron phosphide, boron arsenide, and the like can be used. For high-frequency applications such as those above 1 THz, graphene is suitable as the two-dimensional semiconductor layer 7. For high-frequency applications between 300 GHz and 1 THz, transition metal dichalcogenides such as MoS₂ and WS₂ are suitable as the two-dimensional semiconductor layer 7. For relatively low frequency applications such as logic circuits, In₂O₃ and transition metal dichalcogenides are suitable as the two-dimensional semiconductor layer 7.

The electrodes 8 and 9 are made of metals such as Au, Al, In, Bi, Ni, Pd, Ti, and Pt, or transparent conductive oxides such as ITO or FTO. The electrode 8 is overlaid on a portion of the two-dimensional semiconductor layer 7 where it covers the graphene layer 3 and functions as the source electrode of the short-gate-length transistor 100. The electrode 9 is overlaid on a portion of the two-dimensional semiconductor layer 7 where it covers the lower plane 23 and functions as the drain electrode of the short-gate-length transistor 100.

In the short-gate-length transistor 100 having the basic structure described above, the plane on which the graphene layer 3 is formed and the two-dimensional semiconductor layer 7 covering the vertical plane 22 are orthogonal to each other, and the edge 31 of the graphene layer 3 faces the two-dimensional semiconductor layer 7 across the insulating film 6, so the thickness of the graphene layer 3 defines the gate length of the transistor 1. If the graphene layer 3 is a monatomic layer of graphene, the gate length of the short-gate-length transistor 100 can be reduced to 0.3 nm. Even if the graphene layer 3 is a multilayer graphene film, a gate length of a few nm or less, corresponding to the thickness of the graphene layer 3, can be achieved.

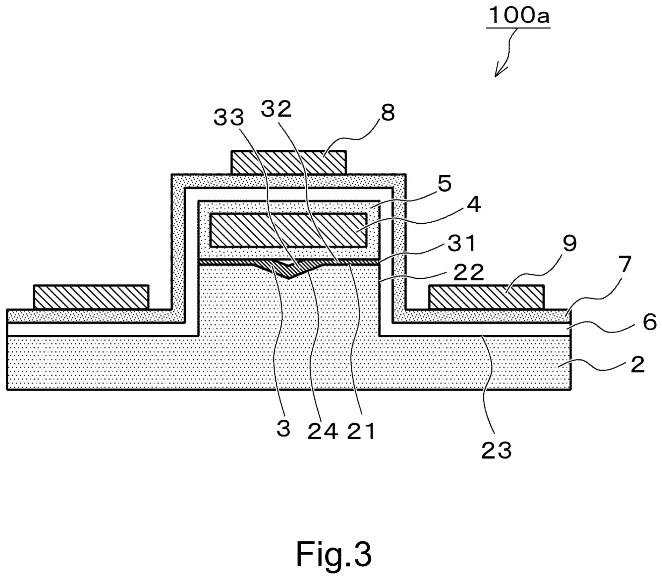

The short-gate-length transistor formed in the first region R1 may have the structure shown in Fig. 3 to achieve a single-atom-layer gate length while suppressing gate resistance. FIG. 3 is a cross-sectional diagram showing the structure of a modified example of the short-gate-length transistor 100a according to the modified example. The short-gate-length transistor 100a, similar to the aforementioned short-gate-length transistor 100, comprises a graphene layer 3, a shielding layer 4, an insulating layer 5, an insulating film 6, a two-dimensional semiconductor layer 7, an electrode 8, and an electrode 9 in the first region R1 of the substrate 2. The first region R1 of substrate 2 has an inclined plane 24 in addition to the uppermost plane 21, the vertical plane 22, and the lower plane 23. In the substrate 2, at least the uppermost plane 21 and the inclined plane 24 are made of single-crystal silicon carbide. The inclined plane 24 is a non-parallel (inclined) plane adjacent to the uppermost plane 21, provided at the end opposite the edge contacting the vertical plane 22 of the uppermost plane 21. The inclination angle of the inclined plane 24 may be arbitrary, but may be set to, for example, 45°, 22°, etc. Furthermore, the inclination angle of the inclined plane 24 need not be constant; it may, for example, be formed as a curved surface. Such an inclined plane 24 is provided prior to the formation of the graphene layer 3. Then, in the short-gate-length transistor 100a, the graphene layer 3 is formed from the uppermost plane 21 across the inclined plane 24 simultaneously. Because the growth rate of graphene on the inclined plane 24 is faster than the growth rate of graphene on the uppermost plane 21, the (0001) plane of silicon carbide, multiple layers (preferably 10-20 layers) of graphene are grown on inclined plane 24 while a single layer of graphene is grown on the uppermost plane 21. Therefore, the graphene layer 3 in the short-gate-length transistor 100a is formed from the uppermost plane 21 across the inclined plane 24, with single-layer graphene 32 near the edge 31 and transitioning to multilayer graphene 33 on the inclined plane 24 in the inner region. The distance from the ridge where the uppermost plane 21 intersects the vertical plane 22 to the inclined plane 24 (i.e., the length of the uppermost plane 21) may be a sufficient distance to prevent the formation of multilayer graphene from extending near the edge 31 (e.g., several hundred nm).

By providing the shielding layer 4, the insulating layer 5, the insulating film 6, the two-dimensional semiconductor layer 7, the electrode 8, and the electrode 9, similar to those of the short-gate-length transistor 100, on the graphene layer 3 described above, the short-gate-length transistor 100a is formed. Note that although the inclination of the underlying inclined plane 24 may result in a depression in the graphene layer 3 at the inclined plane 24 location, it is preferable to fill this depression with insulating material or the like before stacking the shielding layer 4, the insulating film 6, and the two-dimensional semiconductor layer 7, thereby ensuring a flat surface.

In the short-gate-length transistor 100a configured as described above, in addition to the same effects as the transistor 1 of the first embodiment, the graphene layer 3 as a whole can be made low-resistance because the carrier density increases due to the multilayer graphene layer 3. On the other hand, at the edge 31 of the graphene layer 3, the single-layer graphene functions as a gate electrode by facing the two-dimensional semiconductor layer 7 across the insulating film 6. This allows the gate length of the transistor 1 to be reduced to the thickness of a single atom (approximately 0.3 nm).

In the second region R2, the graphene layer 3 is patterned into a desired shape, as shown in Fig. 1, to form an antenna element 200 and a connection portion 210. The antenna element 200 has a structure with the graphene layer 3 patterned into a shape that achieves the desired antenna characteristics. A metal film such as Au or a protective film such as an insulator may be overlaid on a portion or all of the patterned graphene. Graphene has higher values of various properties such as electrical conductivity, carrier mobility, and thermal conductivity than copper (Cu) and other metals and ITO, so it is possible to achieve antenna properties superior to those of Cu, and to suppress property degradation even when antenna size is reduced. The graphene layer 3 forming the antenna element 200 in the second region R2 and the graphene layer 3 forming the gate of the short-gate-length transistor 100 in the first region R1 may be formed as a continuous graphene film. That is, the gate of the short-gate-length transistor 100 and the antenna element 200 may be electrically connected using the graphene layer 3 as wiring. This allows the wiring length connecting the gate of the short-gate-length transistor 100 and the antenna element 200 to be made extremely short.

The connection portion 210 is the wiring connecting the electrode 312 of the amplifier of the GaN device 310, described later, to the antenna element 200. The connection portion 210 may be configured such that the GaN layer 300, described later, is not provided thereon, or the GaN layer 300 may be provided overlaid on a portion or all of the connection portion 210. The connection portion 210 may be formed by patterning the graphene layer 3 or by a metal film such as Au. A portion of the connection portion 210 may be formed by a metal film, while another portion may be formed by graphene; and there may be portions where the metal film is overlaid on the graphene. If the antenna element portion 200 and the connection portion 210 are formed solely of graphene, transparent wiring can be achieved. The connection portion 210 should be formed as short as possible (e.g., preferably less than 100 µm, more preferably less than 30 µm, and even more preferably less than 10 µm transmission distance) so that the signal transmitted between the GaN device 310 and the antenna element 200 is not degraded.

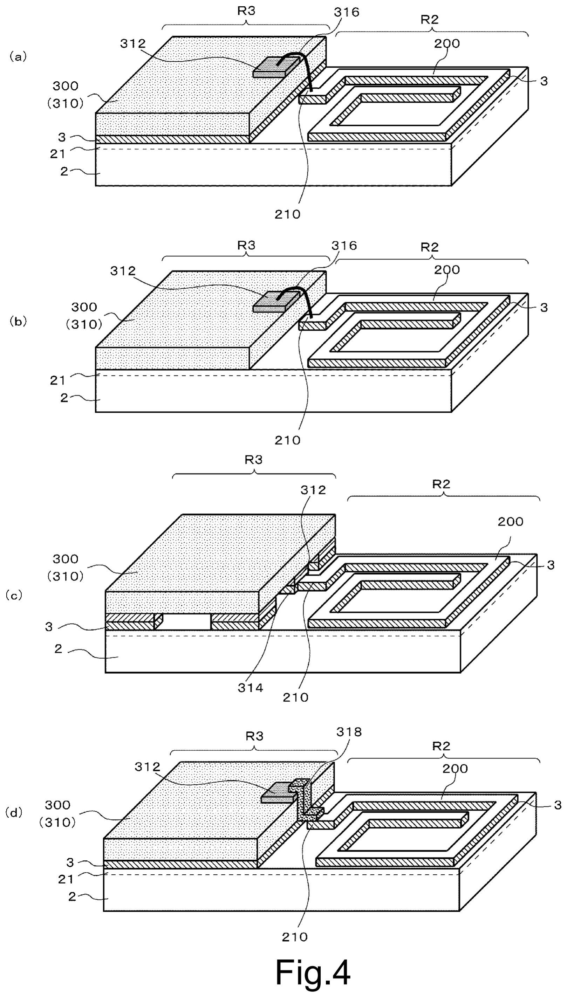

In the third region R3, the gallium nitride layer 300 is stacked on top of the substrate 2. As an example, the gallium nitride layer 300 is overlaid on the graphene layer 3 as shown in Fig. 4(a). In this structure, the graphene layer 3 functions as a buffer layer between the substrate 2 and the GaN layer 300 to relieve stress. As another example, the gallium nitride layer 300 may be provided directly on the substrate 2 without the graphene layer 3, as shown in Fig. 4(b). In the gallium nitride layer 300, the gallium nitride device 310, which is an active element such as an amplifier, is formed using a device capable of high-speed operation, such as a HEMT (High Electron Mobility Transistor). Although not shown in Fig. 4, a metal film (e.g., Au film) to form an electrode or a wiring pattern, a protective film, or the like may be provided over the graphene layer 3 and gallium nitride layer 300 as needed.

The gallium nitride device 310 may include other active elements in addition to the aforementioned amplifier. The gallium nitride device 310 may include an electrode 312 to which wiring from an external component (e.g., antenna element 200 or connection portion 210) is connected. The electrode 312 may be provided on the surface of the gallium nitride layer 300 facing the substrate 2 or on the surface opposite to the surface facing the substrate 2.

When the electrode 312 is provided on the surface of the gallium nitride layer 300 facing the substrate 2, the electrode 312 and the electrode pad 314 provided at one end of the connection portion 210 may be connected directly or indirectly with a conductor between them, as shown in Fig. 4(c). When the electrode 312 is provided on the opposite surface of the gallium nitride layer 300 from the surface facing the substrate 2, the electrode 312 may be connected to the connection portion 210 by wire bonding 316, as shown in Fig. 4(a) or Fig. 4(b). Alternatively, as shown in Fig. 4(c), a conductor layer 318, such as metal, graphene, etc., may be added to connect the electrode 312 to the connection portion 210.

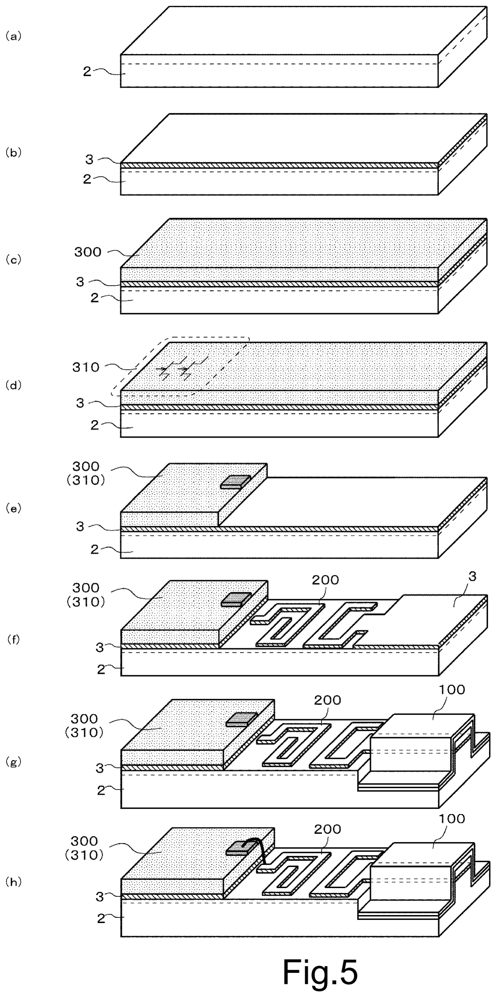

As a modification of the third region, a gallium nitride layer 300 is provided on the substrate 2 without epitaxial growth. Instead, a separate gallium nitride device 310 may be prepared and bonded to the third region R3 of the substrate 2 having the graphene layer 3, thereby forming the gallium nitride layer 300. The structure shown in (c) in Fig. 5 corresponds to the configuration of this modification.

The integrated circuit 1 achieves the desired functionality by arbitrarily arranging the aforementioned first region R1, second region R2, and third region R3, along with other necessary circuit elements, on the substrate 2.

The manufacturing method of integrated circuit 1 will then be described. Fig. 5 shows the first example of a procedure for fabricating the integrated circuit 1.

As shown in Fig. 5, a substrate 2 is first prepared ((a) in Fig. 5). At least the uppermost plane in the substrate 2 is a single-crystal silicon carbide, as described above. The crystal structure of silicon carbide on this uppermost plane is preferably of 4H-SiC, 6H-SiC, or 3C-SiC.

When a hybrid substrate with a single-crystal layer of silicon carbide on an insulator is used as the substrate 2 instead of a single-crystal substrate of silicon carbide, any of single crystal silicon, sapphire, polycrystalline silicon, alumina, silicon nitride, aluminum nitride, diamond, or polycrystalline silicon carbide is used as the base substrate, and a film of silicon oxide, single crystal silicon, polycrystalline silicon, amorphous silicon, alumina, silicon nitride, silicon carbide, aluminum nitride, or diamond is provided on the base substrate as necessary, and the base substrate and silicon carbide substrate are bonded together following surface treatment of their bonding surfaces. Then, a hybrid substrate with a single crystal layer of silicon carbide thinned by grinding and polishing, ion implantation stripping method etc. can be fabricated. In the ion implantation stripping method, hydrogen or helium ions are implanted into the silicon carbide substrate before peeling, and after bonding, the substrate is peeled off at the ion-implantation interface by heat treatment. After fabricating the hybrid substrate described above, a hybrid substrate with a single-crystal silicon carbide layer as the insulator can be obtained by performing CVD of polycrystalline silicon carbide on the surface and then removing the base substrate.

Although not shown in the drawing, when forming a short-gate-length transistor 100a in the first region R1, the inclined plane 24 is formed at a portion where the short-gate-length transistor 100a is to be formed.

Subsequently, the substrate 2 is preferably heated to 1,100°C or higher to sublimate silicon atoms (Si) near the uppermost plane 21 (and inclined plane 24) of the substrate 2 to form a graphene film of the desired thickness (e.g., 50 to 1,500 nm) to form graphene layer 3 ((b) in Fig. 5). An example of typical growth conditions for graphene is heating for 5 to 30 minutes in an argon (Ar) atmosphere at an atmospheric pressure of 10⁵ Pa (1 bar) and a temperature of 1500 to 1600°C. When Si is sublimated, a nanocarbon film of either fullerene, graphene, or carbon nanotube is formed, but the preparation conditions should be adjusted appropriately to obtain graphene. The graphene layer 3 formed in this way grows so-called epitaxially so that the crystal is oriented in a predetermined direction relative to the crystal plane of the uppermost silicon carbide single crystal of the substrate 2, which serves as the base.

Then, gallium nitride is epitaxially grown using the graphene layer 3 as a buffer layer (i.e., a nucleation layer (template layer) for gallium nitride epi-crystals) to form the gallium nitride layer 300 ((c) in Fig. 5). Gallium nitride may be epitaxially grown by, for example, metal organic chemical vapor deposition (MOCVD) method. Specifically, trimethylgallium (TMGa), trimethylaluminum (TMAl), and ammonia (NH₃) may be used as precursors for Ga, Al, and N, respectively, and H₂ and N₂ may be used as carrier gases. Prior to film deposition, the substrate 2 with graphene layer 3 may be thermally cleaned at 1100°C for about 5 minutes in an H₂ atmosphere. An AlN buffer layer of several 10 to several 100 nm may be grown on the substrate surface after cleaning, followed by the growth of an undoped gallium nitride layer 300 about 2 µm thick at 1050°C. The AlN buffer layer may be grown so that a high-temperature AlN buffer layer grown at about 1080°C is stacked on top of a low-temperature AlN buffer layer grown at about 780°C. In the above example, the graphene layer 3 is used as a nucleation layer (template layer) for the gallium nitride epi-crystals. However, before growing the gallium nitride epi-crystals, the graphene layer 3 may be removed for the area where gallium nitride is to be grown (that is, the area where the active element portion is to be provided), so that gallium nitride is directly grown on the silicon carbide single crystal of the uppermost plane 21 of substrate 2.

Then, active elements such as HEMTs, passive elements such as resistors, capacitors, and inductors, wiring, electrodes, etc. are formed in the grown gallium nitride layer 300 to form the gallium nitride device 310 including amplifiers, etc. ((d) in Fig. 5).

Next, the gallium nitride layer 300 is removed from areas other than the gallium nitride device 310 by etching, exposing the graphene layer 3 in the regions that are to be the first region R1 and the second region R2 ((e) in Fig. 5). In addition, the antenna element portion 200 and the connection portion 210 are patterned on the graphene layer 3 ((f) in Fig. 5). When patterning the graphene layer 3, the graphene layer 3 is to be left intact in the region that becomes the first region R1. This patterning can be performed, for example, by depositing an Au film on the graphene layer 3, patterning the Au film using photolithography and etching techniques, removing the exposed graphene not covered by the Au film by UV-ozone treatment, etc., and then removing the unnecessary parts of the Au film

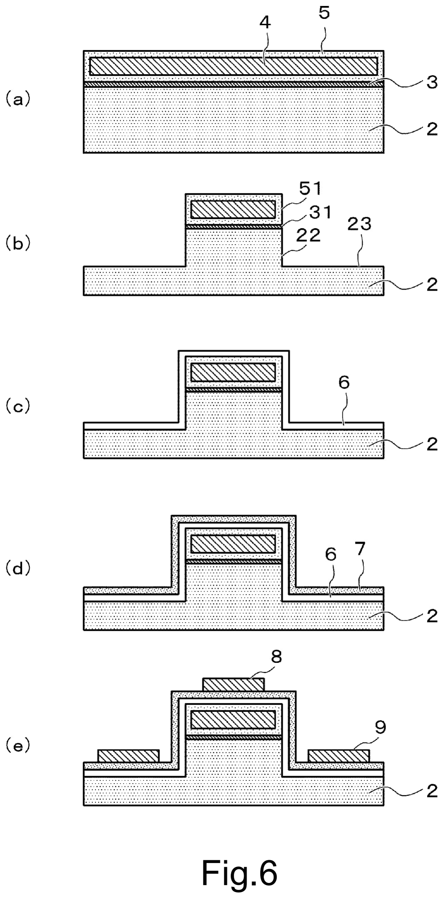

Subsequently, a short-gate-length transistor 100 or 100a is formed in the region that is to become the first region R1 ((g) in Fig. 5). The detailed procedure for forming the short-gate-length transistor 100 is shown in Fig. 6. That is, the shielding layer 4 of Al is formed in the region that becomes the first region R1 where the graphene layer 3 is exposed. During the formation of the shielding layer 4, the insulating layer 5 of natural oxide film is formed to cover the surface of the shielding layer 4 ((a) in Fig. 6). When using materials other than aluminum that do not form a natural oxide film as the shielding layer 4, it is advisable to form an insulating layer above and below the shielding layer 4 to ensure electrical insulation between the shielding layer 4 and the graphene 3 or electrode 8. Then, by performing microfabrication using reactive ion etching or neutral beam etching with chlorine or fluorine gas, a vertical plane 22 and a lower plane 23 are formed on the substrate 2 by digging down a portion of the first region R1 of the substrate 2, and the shielding layer 4 is processed to align with the vertical plane 22 (Fig. (b) in Figure 6). During the microfabrication process, the side surface of the shielding layer 4 is exposed, but a new natural oxide film insulating layer 5 is formed to cover the exposed surface. The vertical plane 22 and lower plane 23 formed by the microfabrication process lack graphene layer 3, but the single-layer graphene layer 3 remains on the uppermost plane 21 that is left intact. Subsequently, the insulating film 6 is deposited ((c) in Fig. 6). In the example shown in (c) in Fig. 6, the insulating film 6 is formed to cover the top surface of the insulating layer 5, extending down through the end plane 51, edge 31, and vertical plane 22 to the lower plane 23. As long as the insulating film 6 covers at least the vertical plane 22, edge 31, and end face 51 of the substrate 2, it may not be necessary to be formed on other portions. Subsequently, a two-dimensional semiconductor layer 7 is deposited to cover the uppermost plane 21, the vertical plane 22, and the lower plane 23 ((d) in Fig. 6). At this time, for portions where there is the graphene layer 3, the shielding layer 4, the insulating layer 5, and/or the insulating film 6, the two-dimensional semiconductor layer 7 is formed overlaid to cover these as well. Then, an electrode 8 is formed overlaid on a portion where the graphene layer 3 is covered by the two-dimensional semiconductor layer 7, and an electrode 9 is formed overlaid on the region where the lower plane 23 is covered by the two-dimensional semiconductor layer 7 ((e) in Fig. 6). Accordingly, the structure of the short-gate-length transistor 100 is completed.

Returning to Fig. 5, finally, by forming mutual connections between the first region R1, the second region R2, and the third region R3 (e.g., connections between the electrode 312 of the gallium nitride device 310 and the connection portion 210), and electrode pads for external connections (e.g., the source electrode, drain electrode, and gate electrode pads for the short-gate-length transistor 100), the integrated circuit 1 is obtained ((h) in Fig. 5).

With the procedure described above, a monolithic integrated circuit 1 can be fabricated on substrate 2, in which the short-gate-length transistor, antenna element, and gallium nitride device are incorporated. The formation of the short-gate-length transistor, the antenna element portion10 and the gallium nitride device may be performed in different orders, or some or all of the processes may be performed simultaneously.

The integrated circuit 1 fabricated as described above features antenna element 200 and short-gate-length transistor 100 positioned in close proximity and connected by a continuous graphene layer 3. This configuration enables suppression of signal degradation even in the signal frequency band exceeding 1 THz.

Furthermore, the integrated circuit 1 fabricated by the above procedure can form both the short-gate-length transistor 100 and the gallium nitride device 310 on the same substrate. This enables broad coverage of the signal frequency band, covering the range from tens of GHz to over 100 GHz and extending to over 1 THz.

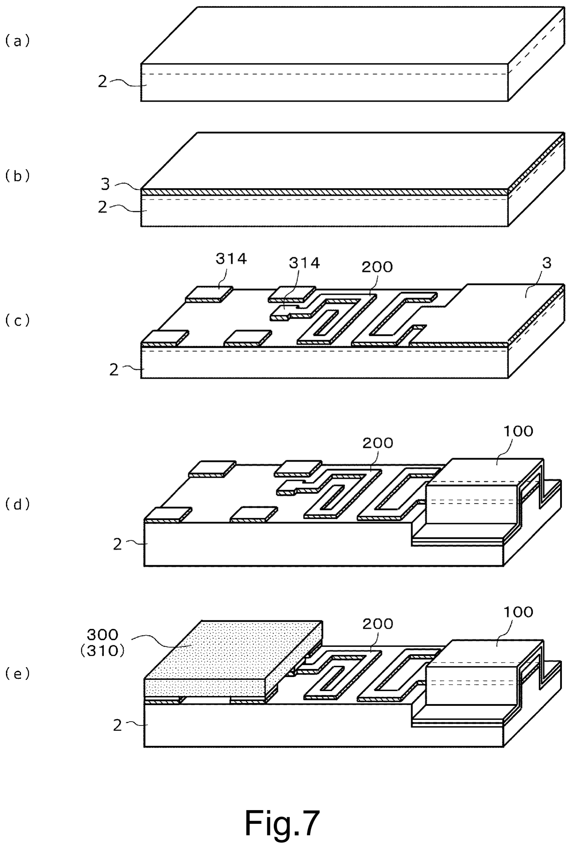

Fig. 7 shows the second example of a procedure for fabricating the integrated circuit 1. This procedure differs from the aforementioned first example in that the gallium nitride layer 300 is not formed by epitaxial growth. Instead, a separate gallium nitride device 310 is prepared and bonded to the substrate 2 with the graphene layer 3, thereby establishing the gallium nitride layer.

In the second example of the procedure to fabricate the integrated circuit, first, a substrate 2 is first prepared ((a) in Fig. 7) using the same method described with reference to (a) and (b) in Fig. 5. The inclined plane 24 is formed if necessary, and the graphene layer 3 is formed ((b) in Fig. 7).

Then, the antenna element portion 200 and the connection portion 210 are patterned on the graphene layer 3 ((c) in Fig. 7). The electrode pad 314, which is connected to the electrode 312 of the integrated circuit 12 when 310 gallium nitride device is bonded in the later stage, is also patterned in a manner that extends from the connection portion 210. When patterning the graphene layer 3, the graphene layer 3 is to be left intact in the region that becomes the first region R1. Other patterns of graphene layer 3 (or Au film on top of it) required for bonding with the gallium nitride device 310 may also be formed. In other words, the graphene layer 3 may function as an adhesive layer to bond the gallium nitride device 310 to the substrate 2. The patterning can be done, for example, by depositing an Au film on the graphene layer 3, patterning the Au film using photolithography and etching techniques, removing the exposed graphene not covered by the Au film by UV-ozone treatment, etc., and then removing the unnecessary parts of the Au film In this way, the antenna element 200 can be formed monolithically on the substrate 2. The pattern used for bonding with the gallium nitride device 310 may be formed by removing the graphene layer 3 and using only a thin metal film, such as Au. The pattern used for bonding to the gallium nitride device 310 may be made of graphene, thin metal films, or stacks of these. The pattern used for bonding to the gallium nitride device 310 may also serve the function of ensuring electrical connection between the elements in the gallium nitride device 310 and the outside, similar to the electrode pad 314 connected to the electrode 312.

Next, using the same method described with reference to Fig. 7, a short-gate-length transistor 100 or 100a is formed in the first region R1 ((d) in Fig. 7).

Then, the gallium nitride device 310 separately prepared is bonded to the appropriate position within the third region R3 of the substrate 2 ((e) in Fig. 7). The gallium nitride device 310 is one in which an active element such as an amplifier is formed on a gallium nitride substrate and then cut to predetermined dimensions. The surface of the gallium nitride device 310 (the surface that is bonded to the substrate 2) is provided with electrodes 312 for receiving and transmitting signals. When the gallium nitride device 310 and the substrate 2 are bonded, the electrode 312 of the gallium nitride device 310 is electrically connected to the electrode pad 314 on the substrate 2. The bonding of the gallium nitride device 310 and the substrate 2 may be performed after activation or surface treatment is performed on the surfaces of both. The gallium nitride device 310 can also be bonded to the substrate 2 by flip-chip bonding. The gallium nitride device 310 bonded to the substrate 2 serves as the gallium nitride layer 300 in the integrated circuit 1.

With the procedure described above, a monolithic integrated circuit 1 can be fabricated on substrate 2, in which the short-gate-length transistor, antenna element, and gallium nitride device are incorporated.

The integrated circuit 1 fabricated as described above features antenna element 200 and short-gate-length transistor 100 positioned in close proximity and connected by a continuous graphene layer 3. This configuration enables suppression of signal degradation even in the signal frequency band exceeding 1 THz.

Moreover, the integrated circuit 1 fabricated by the above procedure can form both the short-gate-length transistor 100 and the gallium nitride device 310 on the same substrate. This enables broad coverage of the signal frequency band, covering the range from tens of GHz to over 100 GHz and extending to over 1 THz.

Furthermore, in the integrated circuit 1 fabricated using the above procedure, the gallium nitride device 310 can be prepared separately and then bonded to the substrate 2, allowing for greater design flexibility of the gallium nitride device. In addition, by preparing multiple types of gallium nitride devices 310 with different functions or performance characteristics for bonding, various variations of integrated circuits 1 can be fabricated while sharing the first region R1 and second region R2, while varying the third region R3.

The present invention is not limited to the above embodiments or examples. Any configuration that has substantially the same technical concept as the one described in the claims of the present invention and that produces similar effects is included in the technical scope of the present invention, no matter what modifications have been made.

### REFERENCE SIGNS LIST

- 1: Integrated circuit
- 2: Substrate
- 21: Uppermost plane
- 22: Vertical plane
- 23: Lower plane
- 24: Inclined plane
- 3: Graphene layer
- 31: Edge
- 4: Shielding layer
- 5: Insulating layer
- 51: End plane
- 6: Insulating film
- 7: Two-dimensional semiconductor layer
- 8, 9: Electrode
- 100, 100a: Short-gate-length transistor
- 200: Antenna element
- 300: Gallium nitride layer
- 310: Gallium nitride device
- 318: Conductor layer
- R1: First region
- R2: Second region
- R3: Third region

## Claims

1. An integrated circuit in which a short-gate-length transistor and an antenna element are integrally formed, comprising:
a substrate at least whose uppermost plane is a single crystal of silicon carbide with a vertical plane intersecting the uppermost plane and extending downwardly therefrom, and a lower plane substantially parallel to the uppermost plane and intersecting the vertical plane; and
a single-crystal graphene layer provided in contact with the uppermost plane of the substrate,
wherein the short-gate-length transistor comprises:
a gate electrode at the edge where the graphene layer intersects the vertical plane;
an insulating film formed to cover at least the vertical plane and edges of the graphene layer;
a two-dimensional semiconductor layer formed to cover the uppermost plane, the vertical plane, and the lower plane, the two-dimensional semiconductor layer being also formed to cover the graphene layer and/or insulating film at a portion where the graphene layer and/or insulating film exists;
a source electrode provided at a portion where the uppermost plane is covered by the two-dimensional semiconductor layer; and
a drain electrode provided at a portion where the lower plane is covered by the two-dimensional semiconductor layer, and
wherein the antenna element is formed by patterning the graphene layer.

2. The integrated circuit according to claim 1, wherein, in the graphene layer, the portion constituting the gate electrode in the short-gate-length transistor and the portion constituting the antenna element are formed as a continuous graphene film.

3. The integrated circuit according to claim 1, further comprises a gallium nitride layer in the area on the substrate where the short-gate-length transistor and antenna element are not provided, and
wherein an active element is formed in the gallium nitride layer.

4. An integrated circuit comprising:
a substrate at least whose uppermost plane is a single crystal of silicon carbide with a vertical plane intersecting the uppermost plane and extending downwardly therefrom, and a lower plane substantially parallel to the uppermost plane and intersecting the vertical plane;
a single-crystal graphene layer provided in contact with the uppermost plane of the substrate; and
a gallium nitride layer provided on the substrate,
wherein an active element portion formed on the gallium nitride layer and a short-gate-length transistor using the graphene layer as a gate are integrally formed, and
wherein the short-gate-length transistor comprises:
a gate electrode at the edge where the graphene layer intersects the vertical plane;
an insulating film formed to cover at least the vertical plane and edges of the graphene layer;
a two-dimensional semiconductor layer formed to cover the uppermost plane, the vertical plane, and the lower plane, the two-dimensional semiconductor layer being also formed to cover the graphene layer and/or insulating film at a portion where the graphene layer and/or insulating film exists;
a source electrode provided at a portion where the uppermost plane is covered by the two-dimensional semiconductor layer; and
a drain electrode provided at a portion where the lower plane is covered by the two-dimensional semiconductor layer.

5. The integrated circuit according to any one of claims 1 to 4, wherein the short-gate-length transistor further includes a shielding layer of a conductor on the graphene layer constituting the gate, and an insulating layer is provided on both the front and back sides of the shielding layer.

6. The integrated circuit according to any one of claims 1 to 4, wherein at least the edge portion of the graphene layer is a monatomic layer of graphene.

7. The integrated circuit according to claim 6, wherein the substrate includes an inclined plane that is non-parallel to the uppermost plane, positioned distant from the edge where the uppermost plane and the vertical plane intersect,
the graphene layer is formed extending from the uppermost plane across the inclined plane, and
the graphene layer on the inclined plane is multilayer graphene.

8. The integrated circuit according to any one of claims 1 to 4, wherein the substrate is a hybrid substrate with a single crystal layer of silicon carbide fabricated on an insulator base substrate.

9. The integrated circuit according to claim 3 or 4, wherein the gallium nitride layer is provided to cover a portion of the graphene layer.

10. The integrated circuit according to claim 9, wherein the gallium nitride layer is a layer epitaxially grown on the graphene layer as a buffer layer.

11. The integrated circuit according to claim 3 or 4, wherein active elements formed in the gallium nitride layer include an amplifier using a HEMT (High Electron Mobility Transistor).

12. A method for manufacturing an integrated circuit in which a short-gate-length transistor and an antenna element are integrally formed, comprising:
a step of preparing a substrate at least whose uppermost plane is a single crystal of silicon carbide;
a step of forming a graphene layer on the uppermost plane of the substrate;
in the area of the first region of the substrate where the short-gate-length transistor is formed:
a step of forming, by microfabrication, on the substrate, a vertical plane intersecting the uppermost plane and extending downward therefrom, and a lower plane substantially parallel to the uppermost plane and intersecting the vertical plane, while leaving a portion of the graphene layer intact, by removing the graphene layer and the upper portion of the substrate from the other portion;
a step of depositing an insulating film to cover at least the vertical plane and edges of the graphene layer;
a step of depositing a two-dimensional semiconductor layer to cover the uppermost plane, the vertical plane, and the lower plane, and to also cover the graphene layer and/or insulating film where the graphene layer and/or insulating film exists;
a step of forming an electrode overlaid on a portion where the graphene layer is covered by the two-dimensional semiconductor layer, and forming an electrode overlaid on a portion where the lower plane is covered by the two-dimensional semiconductor layer; and
a step of forming an antenna element by patterning the graphene layer, in the second region, where the antenna element is formed, of the substrate.

13. The method for manufacturing an integrated circuit according to claim 12, further comprises:
a step of epitaxially growing a gallium nitride layer using the graphene layer as a buffer layer;
a step of removing the gallium nitride layer to expose the graphene layer in the first region and the second region; and
a step of forming an active element portion including an amplifier on the remaining gallium nitride layer.

14. The method for manufacturing an integrated circuit according to claim 12 further comprises:
a step of removing a portion of the graphene layer;
step of epitaxially growing a gallium nitride layer in the area where the graphene layer has been removed; and
step of forming an active element portion including an amplifier in the gallium nitride layer,
wherein the first region and the second region are provided in the region where the graphene layer remains.

15. A method for manufacturing an integrated circuit in which a short-gate-length transistor and an active element formed in a gallium nitride layer are integrally formed, comprising:
a step of preparing a substrate at least whose uppermost plane is a single crystal of silicon carbide;
a step of forming a graphene layer on the uppermost plane of the substrate;
a step of epitaxially growing a gallium nitride layer using the graphene layer as a buffer layer;
in the area of the first region of the substrate where the short-gate-length transistor is formed:
a step of removing the gallium nitride layer to expose the graphene layer;
a step of forming, by microfabrication, on the substrate, a vertical plane intersecting the uppermost plane and extending downward therefrom, and a lower plane substantially parallel to the uppermost plane and intersecting the vertical plane, while leaving a portion of the graphene layer intact, by removing the graphene layer and the upper portion of the substrate from the other portion;
a step of depositing an insulating film to cover at least the vertical plane and edges of the graphene layer;
a step of depositing a two-dimensional semiconductor layer to cover the uppermost plane, the vertical plane, and the lower plane, and to also cover the graphene layer and/or insulating film at a portion where the graphene layer and/or insulating film exists;
a step of forming an electrode overlaid on a portion where the graphene layer is covered by the two-dimensional semiconductor layer, and forming an electrode overlaid on a portion where the lower plane is covered by the two-dimensional semiconductor layer; and
a step of forming an active element portion including an amplifier on the remaining gallium nitride layer.

16. A method for manufacturing an integrated circuit in which a short-gate-length transistor and an active element formed in a gallium nitride layer are integrally formed, comprising:
a step of preparing a substrate at least whose uppermost plane is a single crystal of silicon carbide;
a step of forming a graphene layer on the uppermost plane of the substrate;
a step of removing a portion of the graphene layer;
a step of epitaxially growing a gallium nitride layer in the area where the graphene layer has been removed; and
a step of forming an active element portion including an amplifier in the gallium nitride layer,
in a region where the graphene layer remains:
a step of forming, by microfabrication, on the substrate, a vertical plane intersecting the uppermost plane and extending downward therefrom, and a lower plane substantially parallel to the uppermost plane and intersecting the vertical plane, while leaving a portion of the graphene layer intact, by removing the graphene layer and the upper portion of the substrate from the other portion;
a step of depositing an insulating film to cover at least the vertical plane and edges of the graphene layer;
a step of depositing a two-dimensional semiconductor layer to cover the uppermost plane, the vertical plane, and the lower plane, and to also cover the graphene layer and/or insulating film at a portion where the graphene layer and/or insulating film exists; and
a step of forming an electrode overlaid on a portion where the graphene layer is covered by the two-dimensional semiconductor layer, and forming an electrode overlaid on a portion where the lower plane is covered by the two-dimensional semiconductor layer.

17. The method for manufacturing an integrated circuit according to claim 12 further comprises a step of providing a gallium nitride layer by bonding a gallium nitride device with an active element portion including an amplifier to the graphene layer on the substrate.

18. The method for manufacturing an integrated circuit according to claim 17, wherein, in the step of forming the antenna element, an electrode pad and a connection portion connecting the antenna element to the electrode pad are formed together with the antenna element, and
in the step of providing the gallium nitride layer, the gallium nitride device is bonded to the graphene layer on the substrate so that an electrode on the gallium nitride device and the electrode pad are electrically connected.

19. The method for manufacturing an integrated circuit according to any one of claims 12 to 18, wherein, in the step of forming the graphene layer, the graphene layer is epitaxially grown by sublimating the silicon atoms in a single crystal of silicon carbide on the uppermost plane of the substrate.

20. The method for manufacturing an integrated circuit according to any one of claims 12 to 18, wherein the substrate is a hybrid substrate with a single crystal layer of silicon carbide fabricated on an insulator base substrate.
